# EUROPEAN PATENT SPECIFICATION

(11) **EP 1 696 046 B1**
(45) Date of publication and mention of the grant of the patent: **14.04.2010**
(21) Application number: 04807182.3
(22) Date of filing: 16.12.2004
(51) Int. Cl.: C22C 49/14, C22C 47/14, B22F 3/105

(54) **PROCESS FOR PRODUCING A METAL-BASED CARBON FIBER COMPOSITE MATERIAL**
VERFAHREN ZUR HERSTELLUNG EINES METALLBASIS-KOHLEFASER-VERBUNDMATERIALS
PROCEDE DE FABRICATION D'UN MATERIAU COMPOSITE A BASE DE METAL ET FIBRE DE CARBONE

(30) Priority: 18.12.2003 JP 2003421619
(43) Date of publication of application: 30.08.2006
(73) Proprietor: Shimane Prefectural Government, Matsue-shi Shimane 690-8501 (JP)
(72) Inventor: SATO, Kiminori, Matsue-shi, Shimane 690-0816 (JP); OZOE, Nobuaki, Matsue-shi, Shimane 690-0816 (JP); OGAWA, Jinichi, Matsue-shi, Shimane 690-0816 (JP); UENO, Toshiyuki, Matsue-shi, Shimane 690-0816 (JP); KOMATSUBARA, Satoshi, Matsue-shi, Shimane 690-0816 (JP)
(74) Representative: Winter, Brandl, Fürniss, Hübner Röss, Kaiser, Polte Partnerschaft Patent- und Rechtsanwaltskanzlei
(86) International application number: PCT/JP2004/018823
(87) International publication number: WO 2005/059194

(56) References cited:
- DE-A1- 2 928 955
- GB-A- 1 590 728
- JP-A- 4 019 430
- JP-A- 11 140 559
- JP-A- 50 140 307
- JP-A- 51 005 213
- JP-A- 51 047 508
- JP-A- 52 018 411
- JP-A- 58 091 141
- JP-B1- 44 017 007
- US-A- 4 083 719
- US-A- 5 891 249
- "Semiconductor Thermal Measurement and Management, 2002. Eighteenth Annual IEEE Symposium" 2002, , XP002412500 page 31 * page 30 - page 34 *
- MESHKOV V V ET AL: "SPECIAL FEATURES OF FORMATION OF THE INTERFACES IN ELECTRIC DISCHARGE SINTERING OF METALLIC COMPOSITES" MECHANICS OF COMPOSITE MATERIALS, NEW YORK, NY, US, vol. 21, no. 1, January 1985 (1985-01), pages 25-28, XP001248748 ISSN: 0191-5665

## Description

### Technical Field

The present invention relates to a method for producing a metal-based carbon fiber composite material by using a pulsed electric current sintering. More specifically, the present invention relates to a method for producing a metal-based carbon fiber composite material having a high thermal conductivity suitable in dissipating the heat from equipment working from ordinary temperature to several hundred degrees Celsius of temperature.

### Background Art

Conventionally, metals such as aluminum and copper having a high thermal-conductivity or their alloys have been used in heat-dissipating members (base plate, heat sink, heat spreader and the like) for semiconductor-used electronic equipment and a power module. However, there is a marked tendency that an amount of heat generated from the equipment increases in association with sophistication of the equipment. Further, heat-dissipating members have been required to be made smaller in size and lighter in weight, as the equipment is made smaller and lighter.

With regard to the above-described problem, attention has been paid to a metal-based carbon fiber composite material in which carbon fiber excellent in thermal conductivity and also light in weight is used. In general, such metal-based carbon fiber composite material is produced by a liquidized metal impregnation method in which a liquidized metal such as aluminum is impregnated into a preform formed from carbon fibers with or without applying pressure (refer to Patent Document 1).

In forming a metal-based carbon fiber composite material by a liquidized metal impregnation method, there is a problem that carbon fibers react with metal in the liquidized metal to generate metal carbides. For example, carbon fibers react with aluminum in the liquidized metal to form Al₄C₃. It is known that when thus formed carbides such as Al₄C₃ are brought into contact with water or water vapor at ordinary temperature, they are converted to a hydrocarbon gas such as methane and a metal hydroxide, thereby developing voids between the carbon fibers and the metal of a matrix. It is also known that the voids greatly reduce the strength and the thermal conductivity of the composite material.

As a method for inhibiting the formation of carbides in a liquidized metal impregnation method, studies have been made for a method in which coating such as ceramic coating (refer to Patent Document 2) or fluorinated coating (refer to Patent Document 3) is given to carbon fiber. Also, studies have been made for a method in which carbon-based binders (pitch-based resin and the like) are used to form a preform of carbon fibers (refer to Patent Document 4) or a method in which an alloy of metals is used as a liquidized metal to reduce the temperature of the liquidized metal, thereby inhibiting reactions on impregnation of the liquidized metal (refer to Patent Document 5).

Patent Document 1: JP-A-2002-194515
Patent Document 2: JP-A-2001-300717
Patent Document 3: JP-A-H05-125562(1993)
Patent Document 4: JP-A-2000-303155
Patent Document 5: JP-A-H11-256254(1999)
In the document "Semiconductor Thermal Measurement and Management, 2002. Eigteenth Annual IEEE Symposium" 2002, pages 30-34, XP002412500 only a general statement is given in relation to continuous fibres in fibre reinforced composites wherein aluminium and copper can be used as metal matrix material. The result is given in a table according to which copper is used as matrix material and continuous carbon fibre is used as reinforcement so that a thermal conductivity of 400 - 420 W/mK is obtained and according to which aluminium is used as matrix material and continuous carbon fibre is used as reinforcement so that a thermal conductivity of 218 - 290 W/mK is obtained.
The document Meshkov V V et al: "Special features of formation of the interfaces in electric discharge sintering of metallic composites" Mechanics of composite materials, New York, NY, US, vol. 21 no. 1, January 1985 (1985-01), pages 25-28, XP001248748, ISSN 0191-5665 relates to the use of electric discharge sintering based on copper and randomly distributed low-modulus carbon fibres in comparison to those produced by vacuum sintering. Due to the difference in the kinetics of the diffusion processes at the interfacial surface and in the interparticle contacts in the metal powder differences in the physicomechanical properties of the metal-matrix composites produced according to the two methods are obtained.

### Disclosure of the Invention

### Problems to be Solved by the Invention

However; as mentioned above, additional steps and materials are required in both of the method in which the carbon fiber is coated and the method in which carbon-based binders are used to form a preform, and consequently result in an increased cost of composite materials. Further, the method in which the alloy is used as a liquidized metal requires a step of preparing the alloy. Further, all of the methods require a great amount of energy, since the metal or the alloy used as the matrix must be treated at high temperature for liquidizing them.

In contrast, the present invention is to provide a method for producing a metal-based carbon fiber composite material by using commonly available and inexpensive raw materials at less energy consumption, with inhibiting formation of carbides.

### Means for Solving the Problems

The invention provides a method for producing a metal-based carbon fiber composite material according to claim 1. The metal-based carbon fiber composite material is obtained by sintering of metal and carbon fiber, in which the carbon fiber is preferably contained in a range from 10 to 80 % by weight based on a total weight of the composite material, and the composite material is sintered at 70% or more of ideal density and the carbon fiber is continuously aligned from one end of the composite material to the other end. The carbon fiber may be selected from the group consisting of a pitch-based carbon fiber, a PAN-based carbon fiber, a vapor-phase grown carbon fiber, a carbon nanotube, and a nanotube/nanofiber twisted (stranded) wire. The metal may be selected from the group consisting of copper, aluminum, magnesium and alloys thereof. Further, the metal-based carbon fiber composite material preferably has a density of 2.6g/cm³ or lower where aluminum or its alloy is used as metal, 6.8g/cm³ or lower where copper or its alloy is used as metal, and 2.1g/cm³ or lower where magnesium or its alloy is used as metal. It is preferable that the carbon fiber is contained in a range from 45 to 80 % by weight based on the total weight of the composite material. In this case, it is desirable to have a thermal conductivity of 300W/mK or more in the aligning direction of carbon fiber. The above-described metal-based carbon fiber composite material may be used in a heat-dissipating member (base plate, heat sink, heat spreader or the like) for semiconductor-used electronic equipment and a power module.

The method for producing a metal-based carbon fiber composite material of the present invention is characterized by step 1 of obtaining a metal fiber mixture by physically mixing carbon fiber with metal powder, step 2 of filling the metal fiber mixture into a jig, while the metal fiber mixture is aligned, and step 3 of setting the jig in an air, in a vacuum or in an inert gas atmosphere and directly supplying pulse electric current to the metal fiber mixture, with applying the pressure, to effect sintering by the heat generated therefrom. The carbon fiber may be selected from the group consisting of a pitch-based carbon fiber, a PAN-based carbon fiber, a vapor-phase grown carbon fiber, a carbon nanotube, and nanotube/nanofiber twisted wire. The metal may be selected from the group consisting of copper, aluminum, magnesium and alloys thereof. Alternatively, the carbon fiber may be a mixture of pitch-based carbon fiber, PAN-based carbon fiber or nanotube/nanofiber twisted wire with vapor-phase grown carbon fiber or carbon nanotube. Further, in the step 2, the direction of carbon fiber may be controlled in a two-dimensional manner. fiber length of carbon fibers, which are continuous from one end of the composite material to the other end, is the same as the dimensions of the composite material, and the step 1 may be conducted by a physical mixing method in which the direction of the fibers is maintained.

### Advantages of the Invention

By employing the above-described constitution, it become possible to obtain a metal-based carbon fiber composite material which is light in weight and high in thermal conductivity. The obtained composite material is useful as a heat-dissipating member (base plate, heat sink, heat spreader or the like) for semiconductor-used electronic equipment and a power module. Further, the method of the present invention requires no particular additional steps or materials. The inventive method can inhibit the formation of metal carbides resulting from the reaction of metal with carbon fiber. Consequently, the present method can provide a metal-based carbon fiber composite material having excellent properties in a simple and inexpensive manner. Further, in the metal-based carbon fiber composite material of the present invention where the carbon fiber is aligned, it is possible to control the direction of heat flow on the basis of the aligning direction of the carbon fiber. This characteristic is particularly effective in suppressing the heat flow to adjacent devices in a case of electronic equipment in which semiconductors arehighly integrated.

### Brief Description of the Drawings

Fig. 1 is a view illustrating one exemplary equipment used in producing a metal-based carbon fiber composite material of the present invention;
Fig. 2 is an optical photomicrograph illustrating the cross section of the metal-based carbon fiber composite material obtained in Example 1; and
Fig. 3 is a view illustrating one exemplary equipment used in attaching metal powder to carbon fiber that can be used as continuous fiber.

### Description of Symbols

1: vessel
2: die
3: lower punch
4: upper punch
5: platen
6: plunger
7: power source
8: metal fiber mixture
21: unwinding bobbin
22: winding bobbin
23: drying means
24: vessel
25: agitating means
30: fiber bundle
31: metal powder suspension

### Best Modes for Carrying Out the Invention

As will be explained later in detail, the metal-based carbon fiber composite material is obtained by sintering a composite of metal and carbon fiber, which are mixed in advance in a solid phase, in a pulsed electric current sintering method.

Carbon fiber used in the present invention may include a pitch-based carbon fiber, a PAN-based carbon fiber, a vapor-phase grown carbon fiber, a carbon nanotube, or a nanotube/nanofiber twisted wire made by twisting vapor-phase grown carbon fiber or carbon nanotube. Pitch-based carbon fiber and PAN-based carbon fiber are commercially available in a form of several-hundred meters in length, and can be used in the present invention after cut into a desired length. Nanotube/nanofiber twisted wire may be used also in the present invention. Where pitch-based carbon fiber or PAN-based carbon fiber are used, the fiber having a diameter from 5µm to 20µm is appropriate. These carbon fibers may be used in a length of 5mm or more and preferably in a length from 10mm to 1m, depending on the dimension of a desired composite material. Carbon fiber having a length from one end to the other end of a desired composite material is used, in order to align the carbon fiber in one direction and to make it continuous from one end to the other end of the composite material. Such a constitution is effective in achieving a high thermal conductivity.

In contrast, vapor-phase grown carbon fiber and carbon nanotube are known to be available in a fiber length from 100nm to 100µm.

Metals used in the present invention are those having a high thermal conductivity and include aluminum, aluminum alloy, copper, copper alloy, magnesium and magnesium alloy. Where a primary purpose is to attain a higher thermal conductivity, copper or its alloy may be used. Alternatively, where a primary purpose is to attain a lighter weight, aluminum, aluminum alloy, magnesium or magnesium alloy, which are lower in density, may be used. In particular, where a metal-based carbon fiber composite material having a density of 2.6g/cm³ or less is fabricated, it is effective to use aluminum, aluminum alloy, magnesium or magnesium alloy. As will be mentioned later, in forming a metal-based carbon fiber composite material of the present invention, metal is allowed to attach on the surface of carbon fiber. For this purpose, the metal is used as powders having a mean particle diameter from 10nm to 100µm and preferably from 10nm to 50µm.

The metal-based carbon fiber composite material of the present invention comprises 10 to 80%, preferably 30 to 80%, and more preferably 50 to 80% by weight of carbon fiber based on the total weight of the composite material. Then, a relative density of the metal-based carbon fiber composite material of the present invention is 70% or more, preferably 90% to 100% of an ideal density. The "ideal density" described in the present invention means a density which is calculated by densities of carbon fiber and metal used as well as a compositional ratio of carbon fiber and metal, on the assumption that the carbon fiber is filled into the metal matrix without any voids. When the metal-based carbon fiber composite material has the composition and the density in the above-mentioned range, the composite material can achieve a thermal conductivity of 300W/mK (Kelvin/watt/meter) in the arrangement direction of the carbon fiber, although voids are allowed to exist in the material. "Arrangement direction of fiber" described in the present invention means an axial direction of long fibers, where long fibers having a fiber length of 5mm or more are aligned in one direction

Further, in optimizing types of metals used and the compositional ratio of the carbon fiber, the metal-based carbon fiber composite material of the present invention has a density of 2.6g/cm³ or lower, preferably from 2.2 to 2.6g/cm³ and more preferably from 2.2 to 2.5g/cm³, where aluminum or its alloy is used as metal. The metal-based carbon fiber composite material of the present invention has a density of 2.1g/cm³ or lower, preferably from 1.8 to 2.1g/cm³ and more preferably from 1.9 to 2.1g/cm³, where magnesium or its alloy is used as metal. A composite material having such a low density is effective in forming a lightweight heat-dissipating member (base plate, heat sink, heat spreader or the like). Further, where copper or its alloy is used as metal in order to attaining a high thermal conductivity, the metal-based carbon fiber composite material of the present invention should have a density of 6.8g/cm³ or less, preferably in the range from 2.5 to 6.8g/cm³ and more preferably from 2.5 to 4.6g/cm³.

A metal-based carbon fiber composite material of the present invention is effectively used as a heat-dissipating member (base plate, heat sink, heat spreader or the like) for semiconductor-used electronic equipment and a power module. The semiconductor-used electronic equipment may be, for example, a central processing unit (CPU), a storage cell (memory cell), a controller IC for various equipments, a flat panel display, an image processing device, communications devices (wireless and wired communications devices) and photo-electric hybrid circuits which are known in the art. The power module includes a converter and an inverter in which elements such as a thyristor, GTO, IGBT and IEGT are used. Further, it is possible to control the direction of heat flow based on the aligning direction of carbon fiber, since the carbon fibers of the inventive metal-based carbon fiber composite material is aligned. This characteristic is particularly effective in suppressing the heat flow to adjacent devices in a case of electronic equipment in which semiconductors are highly integrated. For example, carbon fibers are aligned in a direction from devices to be cooled to the upside of the equipment, thereby making it possible to move the heat flow substantially toward the upside of the equipment. Where the metal-based carbon fiber composite material of the present invention is used as a heat-dissipating member for a heat sink or a heat spreader, the composite material is processed into an appropriate shape and attached to the equipment in such a way that the heat generated in the equipment is transferred to an intermediate or a final cooling medium. In this instance, at a joining part of the composite material of the present invention and the equipment, a pliant heat transfer medium may be used for filling irregularity of the surfaces of the composite material and the equipment, to attain a uniform heat transfer from the equipment to the composite material. The flexible heat transfer medium may be silicone grease, which may contain dispersed particles having high thermal conductivity such as silver, or heat-transfer sheet.

Hereinafter, a detailed explanation will be made for a method for producing a metal-based carbon fiber composite material of the present invention. The first step of the production method of the present invention is mixing a metal powder and a carbon fiber together in a solid form, to provide a metal fiber mixture having metal attached on the surface of the carbon fiber.

When using long fibers having a fiber length of 5mm or more (pitch-based carbon fiber, PAN-based carbon fiber or nanotube/nanofiber twisted wire), it is preferable to conduct the present step by a physical mixing method which is capable of maintaining the fiber direction of carbon fiber, in order to facilitate a subsequent arrangement step of the metal fiber mixture. In this case, the present step can be conducted by using a rod mill in which rods having an appropriate diameter are used as a grinding medium. A rod mill used in the present step desirably has a sufficiently small diameter to prevent the carbon fibers from being twisted or entangled with each other. Preferably, the rod mill has an inner diameter of from 10mm to 20mm.

In the present step, separately pre-ground metal powder having the above-described particle diameter may be used. Alternatively, in the present step, metal powder having a larger particle diameter may be used and grinding of the metal powder and attachment of the ground powder to carbon fiber may be conducted at the same time.

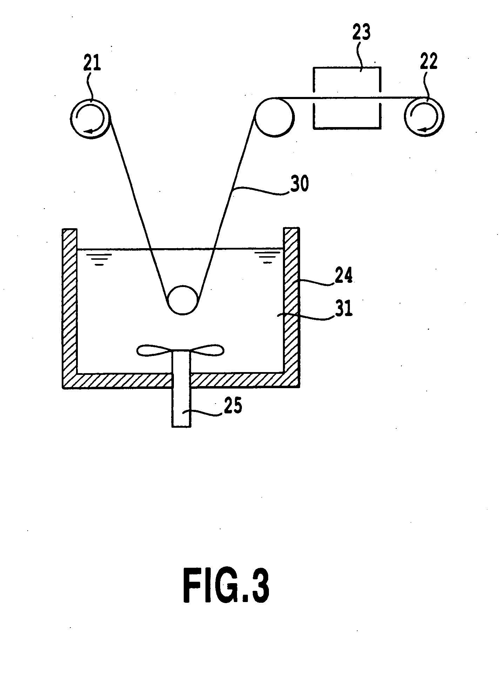

Further, when using a pitch-based carbon fiber, PAN-based carbon fiber and nanotube/nanofiber twisted wire, which can be handled as a continuous fiber, for example, the equipment as illustrated in Fig. 3 is used to immerse the continuous fibers into a suspension in which metal powder is dispersed in a solvent, thereby obtaining a fiber bundle having metal powder attached with a high efficiency and an high accuracy. As used herein, by "To be handled as continuous fibers" , it is meant that a length of the fibers is 100mm or more. In the equipment illustrated in Fig. 3, a fiber bundle 30 is unwound from an unwinding bobbin 21, immersed into a metal powder suspension 31 in a vessel 24 agitated by an agitator 25, and the fiber bundle 30 to which metal powder is attached is wound up by a winding bobbin 22. Herein, before the bundle is wound up by the winding bobbin 22, solvent attached on the fiber bundle 30 may be evaporated and removed by a drying means 23 such as a hot-air dryer. A solvent used for the metal powder suspension 31 may be selected from organic solvents such as methanol, ethanol, propanol, acetone, hexane, benzene, xylene, toluene, dimethyl ether, diethyl ether, ethylmethyl ether and chloroform, where dispersed metal powder is a powder of aluminum, magnesium or their alloys. Where powder of copper and its alloy is dispersed, water may be selected in addition to the above organic solvents. Preferably, the metal powder suspension 31 further comprises a Pluronic-based dispersant (Pluronic (registered trade mark) F-68 and the like) or polyethylene glycol as a dispersant-adhesive, thereby promoting a uniform attachment of metal powder to fiber bundle. Contents of carbon fiber in a composite material obtained by this method are controlled by an amount of metal powder attached to the fiber bundle. In turn, the amount of the attached metal powder can be regulated by controlling an amount of metal powder mixed in the suspension, a length of a path where the fiber bundle is immersed in the metal powder suspension, a speed of the fiber bundle passing through the metal powder suspension and/or a concentration of the dispersant-adhesive.

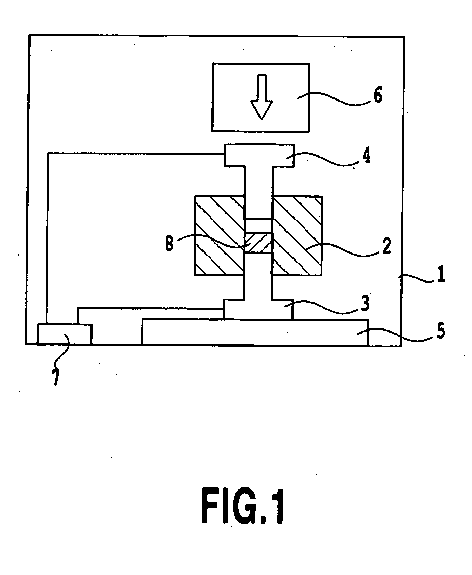

The second step of the production method of the present invention is a step in which a metal fiber mixture (or a metal powder-attached fiber bundle) is aligned and filled into a jig of a sintering equipment. Fig. 1 illustrates the sintering equipment to be used in the present invention. The sintering equipment shown in Fig. 1 is provided with a vessel 1, a jig constituted with a die 2 having a through hole, a lower punch 3 and an upper punch 4 fitted into the through hole, a platen 5 and a plunger 6 giving pressure to the lower punch 3 and the upper punch 4, and a power source 7 connected to the lower punch 3 and the upper punch 4 and supplying electric current to a metal fiber mixture 8.

The metal fiber mixture 8 is filled into a recess formed by fitting the lower punch 3 into the die 2, with aligning fibers in the mixture. When using long fibers having a fiber length of 5mm or more, it is preferable to align the fibers on filling.

Here, when using a metal powder-attached fiber bundle obtained by the above-mentioned suspension immersion method, the metal-powder attached fiber bundle unwound from the winding bobbin can be cut at an appropriate length, and the cut metal-powder attached fiber bundle can be aligned and filled into the recess formed by the die 2 and the lower punch 3. Further, where the dispersant-adhesive is used in the metal powder suspension, it is preferable that the filled metal powder attached fiber bundle is heated up to a temperature from 200 to 400°C to remove the dispersant-adhesive, thereby forming a metal fiber mixture 8 constituted with metal powder and carbon fiber, in a vacuum or in an inert gas atmosphere (nitrogen, argon, helium and the like), either before an upper punch is placed or in a state that low pressure of from 1 to 10MPa is applied to the upper punch after placement onto the mixture. A step of heating and removing the dispersant-adhesive may be conducted in the pulsed electric current sintering equipment which is further equipped with a heating means or may be conducted in a separate heating apparatus. Where copper powder is used as metal powder, the step of heating and removing the dispersant-adhesive may be conducted at an oxidizing atmosphere (air, oxygen-enriched air, pure oxygen and the like).

Next, the upper punch 4 is placed on the filled metal fiber mixture 8, an assembled jig is disposed between a platen 5 and a plunger 6 in a pressing machine inside a vessel 1 to conduct a sintering step. The sintering step is preferably conducted in the air, in a vacuum or in an inert gas atmosphere. In order to make the vessel 1 vacuum, the vessel 1 may be provided with an evacuating port(not illustrated) connected to an appropriate evacuation system. Where a sintering step is conducted in a vacuum, the pressure in the vessel should be maintained in a range from 0 to 20Pa, preferably from 0 to 5Pa. Alternatively, the vessel 1 may be provided with an inert gas inlet and a gas outlet (neither of them is illustrated), by which the vessel 1 is purged by inert gas (nitrogen, argon, helium and the like) to accomplish an inert atmosphere.

Next, the upper punch 4 is pressed by the plunger 6 to apply pressure to the metal fiber mixture 8. The applied pressure should be in a range from 10 to 100MPa, preferably from 20 to 50MPa.

Then, the metal fiber mixture 8 is sintered by energizing with a pulse electric current by using the power source 7 connected to the lower punch 3 and the upper punch 4. The pulse duration of the electric current used herein should be from 0. 005 to 0.02 seconds, preferably from 0.005 to 0.01 seconds, and the current density (based on cross sectional area of the through hole of the die 2) should be 5×10⁵ to 2×10⁷A/m², preferably from 5×10⁶ to 1×10⁷A/m². Voltage for attaining the above current density is usually in a range from 2 to 8V, depending on the resistance value of an electricity-conducting path including the metal fiber mixture 8. Energization by the pulse electric current is continued until a desired sintering is completed, and the duration of the energization will vary, depending on the dimensions of the composite material, the current density and the mixing ratio of carbon fiber.

As described above, the supply of pulse electric current causes a plastic deformation of metal particles and fusion of powders, thereby promoting sintering. Where the pulse electric current is used as described in the present step, the heat generated is concentrated at a site where metal particles are to bind together, unlike a case of heating a metal fiber mixture as a whole, thereby making it possible to use electric energy more effectively and conduct sintering more quickly. Then, this method is advantageous over a conventional liquidized-metal impregnation method in that the metal fiber mixture is not substantially elevated in temperature as a whole and, therefore, carbides are not formed due to reaction between metal and carbon fiber. It is, therefore, possible to obtain a metal-based carbon fiber composite material having excellent properties by using inexpensive carbon fibers to which no coating is given. This method is also advantageous over an ordinary resistance heating method in that plasma generated at an initial stage of the energization acts to remove an adsorbed gas and an oxide film on the powder.

### Example 1

To a rod mill having an inner diameter of 13 mm was added 6 grams of aluminum powder having a mean particle diameter of 30µm (available from Kishida Chemical Co., Ltd.), 3 grams of pitch-based carbon fiber having a fiber length of 20cm and a diameter of 10µm (available from Nippon Graphite Fiber Corporation, YS-95A) and a glass rod (5mm in diameter × 20mm in length). The rod mill was rotated along its axis to mix the ingredients, thereby obtaining a metal fiber mixture.

Next, the metal fiber mixture was filled into the equipment shown in Fig. 1, and a pressure in the equipment is set to 8Pa. The die having a through hole of 20x20cm was used in this example. Into the die is fitted the lower punch to form a recess, and the metal fiber mixture was filled into the recess such that carbon fiber was aligned in one direction. Next, the upper punch was placed on the filled metal fiber mixture, and pressure of 25MPa was applied by using the plunger.

Then, pulse electric current having a pulse duration of 0.01 seconds, a current density of 1×10⁷A/m² (maximum) and a voltage of 5V (maximum) flowed through the metal fiber mixture for 20 minutes by using the power source connected to the upper punch and the lower punch, thereby sintering the metal fiber mixture and fabricating a metal-based carbon fiber composite material having dimensions of 20 × 20 × 8cm.

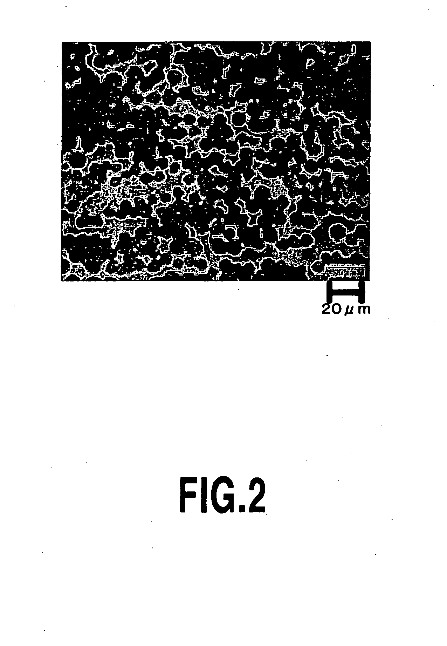

The obtained metal-based carbon fiber composite material contained 45% of carbon fiber based on a total weight of the composite material and had a density of 1.91g/cm³. The ideal density of the composite material was 2.40g/cm³ and therefore the composite material had a relative density of 78%. Fig. 2 shows a optical micrograph illustrating the cross section of the thus obtained composite material. Further, the composite material had a thermal conductivity of 350W/mK, as measured in the aligning direction of the carbon fiber.

### Example 2

- The same procedures as described in Example 1 are repeated, except that the amount of carbon fiber is changed to 4 grams and that of aluminum powder was changed to 4 grams. The obtained metal-based carbon fiber composite material contained 60% of carbon fiber based on a total weight of the composite material and had a density of 1.75g/cm³. The composite material had an ideal density of 2.38g/cm³ and a relative density of 73%. The composite material had a thermal conductivity of 300W/mK, as measured in the aligning direction of the carbon fiber.

### Example 3

In this example, a suspension immersion method was used to prepare a metal fiber mixture, in which an aluminum powder suspension was applied to carbon fiber that can be handled as continuous fiber. The metal fiber mixture was sintered in the pulsed electric current sintering method to provide a metal-based carbon fiber composite material.

Pitch-based carbon fiberhaving a thermal conductivity of 1000W/mK and a diameter of 10µm was used as carbon fiber and a bundle made of 6000 pieces of the fiber was wound up around an unwinding bobbin 2. Flake-like powder, which is 1µm or less in thickness and 30µm in mean representative length toward a surface (in-plane) direction; was used as aluminum powder. The aluminum powder was mixed in ethanol containing 2 % by weight (based on weight of the ethanol) of a dispersant-adhesive (Pluronic (registered trade mark) F68) to form a metal powder suspension. The content of aluminum powder was 30 % by weight based on the weight of the suspension. The bundle of carbon fiber was unwound from the unwinding bobbin, immersed into the metal powder suspension under agitation, taken up in the air, subjected to hot-air drying (50°C) and wound up around a winding bobbin to obtain a bundle of carbon fiber to which aluminum powder is attached.

The obtained aluminum-powder-attached bundle of carbon fiber was unwound and cut into a strip 20mm in length. While the fiber bundle was aligned in one direction, 8 grams of the bundle was laid into the rectangular recess (20mm × 20mm) formed by the lower punch and the die. Then, a pressure in the equipment was set 8Pa and the upper punch was disposed on the laid fiber bundle, to which the pressure of 25MPa was applied by a plunger. Then, pulse electric current having pulse duration of 0.01 seconds; current density of 5×10⁶A/m² (maximum); and voltage of 8V (maximum) flowed for 10 minutes through the fiber bundle by using the power source connected to the upper and lower punches, thereby sintering the aluminum-powder-attached fiber bundle to obtain a metal-based carbon fiber composite material.

The obtained metal-based carbon fiber composite material had a content of 50% of carbon fiber, density of 2.3g/cm³ (95% of ideal density) and thermal conductivity of 400W/mK.

### Example 4

In this example, the suspension immersion method was used to prepare a metal fiber mixture, in which a copper powder suspension was applied to carbon fiber that can be handled as continuous fiber. The metal fiber mixture was then sintered in the pulsed electric current sintering method to provide a metal-based carbon fiber composite material.

Pitch-based carbon fiber having a thermal conductivity of 1000W/mK and a diameter of 10µm was used as carbon fiber and a bundle made of 6000 pieces of the fiber was wound up around an unwinding bobbin. Flake-like powder, which is 1µm or less in thickness and 30µm in mean representative length toward a surface direction, was used as copper powder. The copper powder is mixed in ethanol containing 2 % by weight (based on the weight of ethanol) of a dispersant-adhesive (Pluronic (registered trade mark) F68) to form a metal powder suspension. The content of copper powder was 60 % by weight based on the weight of the suspension. The bundle of carbon fiber was unwound from the unwinding bobbin, immersed into the metal powder suspension under agitation, taken up in the air, subjected to hot-air drying (50°C) and wound up around a winding bobbin to obtain a bundle of carbon fiber to which copper powder is attached.

The obtained copper-powder-attached bundle of carbon fiber was unwound and cut into a strip 20mm in length. While the fiber bundle was aligned in one direction, 12 gram of the bundle was laid into the rectangular recess (20mm × 20mm) formed by the lower punch and the die. Then, a pressure inside the equipment was set 10Pa and the upper punch was disposed on the laid fiber bundle, to which the pressure of 25MPa was applied by a plunger. Then, pulse electric current having pulse duration of 0.01 seconds; current density of 5×10⁶A/m² (maximum); and voltage of 8V (maximum) flowed for 10 minutes through the fiber bundle by using the power source connected to the upper and lower punches, thereby sintering the copper-powder-attached fiber bundle to obtain a metal-based carbon fiber composite material.

The obtained metal-based carbon fiber composite material had a content of 30% of carbon fiber, density of 4.5g/cm³ (97% of ideal density) and thermal conductivity of 550W/mK.

## Claims

1. A method for producing a metal-based carbon fiber composite material comprising the steps of:
step 1: obtaining a metal fiber mixture by physicallymixing carbon fiber with metal powder;
step 2 : filling the metal fiber mixture into a jig, while the metal fiber mixture is aligned, and
step 3: setting the jig in the air, in a vacuum or in an inert gas atmosphere and
directly supplying pulse electric current to the metal fiber mixture, with applying the pressure, to effect sintering by the heat generated therefrom,
**characterized in**
**that** the carbon fiber is aligned in one direction and continuous from one end to the other end of the composite material, and
**that** in step 3 the pulse duration of the electric current is from 0.005 to 0.02 seconds and the current density is 5x10⁵ to 2x10⁷ A/m².

2. The method for producing a metal-based carbon fiber composite material as claimed in Claim 1, wherein in step 1 the metal is used as powders having a mean particle diameter from 10nm to 100µm and the metal-based carbon fiber composite material is produced in step 3 so that its relative density is 70% or more of an ideal density.

3. The method for producing a metal-based carbon fiber composite material as claimed in Claim 1 or 2, wherein the metal is selected from the group consisting of copper, aluminum, magnesium and their alloys and wherein the metal-based carbon fiber composite material is produced in such a manner that its density is
a) 2.6g/cm³ or less where aluminium, aluminium alloy, magnesium or magnesium alloy is used as metal,
b) 6.8 g/cm³ or less where copper or its alloy is used as metal.

4. The method for producing a metal-based carbon fiber composite material as claimed in Claim 3, wherein the metal-based carbon fiber composite material is produced in such a manner that its density is 2.1g/cm³ or less where magnesium or magnesium alloy is used as metal.

5. The method for producing a metal-based carbon fiber composite material as claimed in Claim 1 or 2 wherein the voltage for obtaining the current density in step 3 is 2 to 8V.

6. The method for producing a metal-based carbon fiber composite material as claimed in Claim 1, wherein the carbon fiber is selected from the group consisting of pitch-based carbon fiber, PAN-based carbon fiber, vapor-phase grown carbon fiber, carbon nanotube, and nanotube/nanofiber twisted wire.

7. The method for producing a metal-based carbon fiber composite material as claimed in Claim 1, wherein the carbon fiber is a mixture of pitch-based carbon fiber, PAN-based carbon fiber or nanotube/nanofiber twisted wire with vapor phase grown carbon fiber or carbon nanotube.

8. The method for producing a metal-based carbon fiber composite material as set forth in Claim 1, wherein the step 1 is conducted by a physical mixing method in which the direction of fiber is maintained.

## Patentansprüche

1. Ein Verfahren zum Erzeugen eines Kohlefaser-Verbundmaterials auf Metallbasis, das die Schritte aufweist:
Schritt 1: Erhalten eines Metall-Faser-Gemischs durch das physikalische Mischen von Kohlefaser mit Metallpulver,
Schritt 2: Füllen des Metall-Faser-Gemischs in eine Vorrichtung, während das Metall-Faser-Gemisch ausgerichtet ist, und
Schritt 3: die Vorrichtung der Luft, einem Vakuum oder einer Inertgasatmosphäre aussetzen und Direktzuführen eines elektrischen Impulsstromes zu dem Metall-Faser-Gemisch, wobei Druck ausgeübt würde, um ein Sintern durch die daraus erzeugte Wärme zu bewirken,
**dadurch gekennzeichnet, dass**
die Kohlefaser in eine Richtung ausgerichtet ist und von einem Ende zum anderen Ende des Verbundmaterials kontinuierlich ist, und
dass in Schritt 3 die Impulsdauer des elektrischen Stroms von 0,005 bis 0,02 Sekunden und die Stromdichte 5x10⁵ bis 2x10⁷ A/m² beträgt.

2. Das Verfahren zum Erzeugen eines Kohlefaser-Verbundmaterials auf Metallbasis nach Anspruch 1, wobei in Schritt 1 das Metall als Pulver mit einem mittleren Teilchendurchmesser von 10nm bis 100µm verwendet wird und das Kohlefaser-Verbundmaterial auf Metallbasis in Schritt 3 erzeugt wird, so dass seine relative Dichte 70% oder mehr einer idealen Dichte ist.

3. Das Verfahren zum Erzeugen eines Kohlefaser-Verbundmaterials auf Metallbasis nach Anspruch 1 oder 2, wobei das Metall aus der Gruppe ausgewählt wurde, die aus Kupfer, Aluminium, Magnesium und ihren Legierungen besteht, und wobei das Kohlefaser-Verbundmaterial auf Metallbasis in einer solchen Weise hergestellt wird, dass seine Dichte
a) 2,6 g/cm³ oder weniger ist, wo Aluminium, Aluminiumlegierung, Magnesium oder Magnesiumlegierung als Metall verwendet wird,
b) 6,8 g/cm³ oder weniger ist, wo Kupfer oder seine Legierung als Metall verwendet wird.

4. Das Verfahren zum Erzeugen eines Kohlefaser-Verbundmaterials auf Metallbasis nach Anspruch 3, wobei das Kohlefaser-Verbundmaterial auf Metallbasis in einer solchen Weise erzeugt wird, dass seine Dichte 2,1 g/cm³ oder weniger ist, wo Magnesium oder Magnesiumlegierung als Metall verwendet wird.

5. Das Verfahren zum Erzeugen eines Kohlefaser-Verbundmaterials auf Metallbasis nach Anspruch 1 oder 2, wobei die Spannung zum Erhalten der Stromdichte in Schritt 3 2 bis 8 V ist.

6. Das Verfahren zum Erzeugen eines Kohlefaser-Verbundmaterials auf Metallbasis nach Anspruch 1, wobei die Kohlefaser aus der Gruppe ausgewählt wurde, die aus Kohlefaser auf Pechbasis, Kohlefaser auf PAN-Basis, in Dampfphase gewachsene Kohlefaser, Kohlenstoff-Nanoröhre und verdrillten Nanoröhren/Nanofaser-Draht besteht.

7. Das Verfahren zum Erzeugen eines Kohlefaser-Verbundmaterials auf Metallbasis nach Anspruch 1, wobei die Kohlefaser ein Gemisch aus Kohlefaser auf Pechbasis, Kohlefaser auf PAN-Basis oder verdrilltem Nanoröhren/Nanofaser-Draht mit in Dampfphase gewachsener Kohlefaser oder Kohlenstoff-Nanoröhre ist.

8. Das Verfahren zum Erzeugen eines Kohlefaser-Verbundmaterials auf Metallbasis nach Anspruch 1, wobei Schritt 1 durch ein physikalisches Mischverfahren ausgeführt wird, in dem die Richtung der Faser aufrechterhalten wird.

## Revendications

1. Procédé de production d'un matériau composite de fibre de carbone à base de métal, comprenant les étapes consistant à :
étape 1 : obtenir un mélange fibre-métal en mélangeant physiquement une fibre de carbone avec de la poudre de métal ;
étape 2 : verser le mélange fibre-métal dans un bac, lorsque le mélange fibre-métal est ajusté, et
étape 3 : placer le bac à l'air, dans un vide, ou dans une atmosphère de gaz inerte, et fournir directement un courant électrique impulsionnel au mélange fibre-métal, tout en appliquant une pression, afin de réaliser un frittage par la chaleur engendrée,
**caractérisé en ce que**
la fibre de carbone est alignée suivant une direction et est continue d'une extrémité à l'autre du matériau composite, et **en ce que**,
durant l'étape 3 la durée de l'impulsion du courant électrique est comprise entre 0,005 et 0,02 secondes, et la densité de courant est comprise entre 5 10⁵ et 2 10⁷ A/m².

2. Procédé de production d'un matériau composite de fibre de carbone à base de métal selon la revendication 1, dans lequel à l'étape 1 le métal est sous forme de poudres présentant un diamètre de particule moyen compris entre 10nm et 100µm, et le matériau composite de fibre de carbone à base de métal est produit à l'étape 3 de sorte que sa densité relative est supérieure ou égale à 70 % d'une densité idéale.

3. Procédé de production d'un matériau composite de fibre de carbone à base de métal selon la revendication 1 ou 2, dans lequel le métal est choisi dans le groupe consistant en du cuivre, de l'aluminium, du magnésium, et leurs alliages, et dans lequel le matériau composite de fibre de carbone à base de métal est produit de sorte que sa densité est
a) inférieure ou égale à 2,6 g/cm³ lorsque de l'aluminium, un alliage d'aluminium, du magnésium, ou un alliage de magnésium est utilisé en tant que métal,
b) inférieure ou égale à 6,8 g/cm³ lorsque du cuivre ou un alliage de cuivre est utilisé en tant que métal.

4. Procédé de production d'un matériau composite de fibre de carbone à base de métal selon la revendication 3, dans lequel le matériau composite de fibre de carbone à base de métal est produit de sorte que sa densité est inférieure ou égale à 2,1 g/cm³ lorsque du magnésium ou un alliage de magnésium est utilisé en tant que métal.

5. Procédé de production d'un matériau composite de fibre de carbone à base de métal selon la revendication 1 ou 2, dans lequel la tension pour obtenir la densité de courant à l'étape 3 est comprise entre 2 et 8 V.

6. Procédé de production d'un matériau composite de fibre de carbone à base de métal selon la revendication 1, dans lequel la fibre de carbone est choisie dans le groupe consistant en une fibre de carbone à base de brai, une fibre de carbone à base de PAN, une fibre de carbone obtenue par phase vapeur, un nanotube de carbone, et un fil torsadé de nanofibre/nanotube.

7. Procédé de production d'un matériau composite de fibre de carbone à base de métal selon la revendication 1, dans lequel la fibre de carbone est un mélange de fibre de carbone à base de brai, de fibre de carbone à base de PAN, ou d'un fil torsadé de nanofibre/nanotube, avec de la fibre de carbone obtenue par phase vapeur, ou des nanotubes de carbone.

8. Procédé de production d'un matériau composite de fibre de carbone à base de métal selon la revendication 1, dans lequel l'étape 1 est réalisée par un procédé de mélange physique dans lequel la direction de la fibre est maintenue.
